# EUROPÄISCHE PATENTSCHRIFT

(11) **EP 0 603 587 B1**
(45) Veröffentlichungstag und Bekanntmachung des Hinweises auf die Patenterteilung: **25.09.1996**
(21) Anmeldenummer: 93119165.4
(22) Anmeldetag: 29.11.1993
(51) Int. Cl.: H01J 37/34

(54) **Plasmaerzeugungsvorrichtung**
Plasma generating apparatus
Appareil de génération de plasma

(30) Priorität: 23.12.1992 CH 3911/92
(43) Veröffentlichungstag der Anmeldung: 29.06.1994
(73) Patentinhaber: BALZERS AKTIENGESELLSCHAFT, FL-9496 Balzers (LI)
(72) Erfinder: Grünenfelder, Pius, CH-7323 Wangs (CH)

(56) Entgegenhaltungen:
- EP-A- 0 065 277
- EP-A- 0 503 138
- US-A- 4 466 877

## Beschreibung

Die Erfindung betrifft eine Magnetronplasmaerzeugungsvorrichtung zur Behandlung von Substraten in einer Vakuumkammer mit einer Kathode, die an ihrer Oberfläche das zu bearbeitende Material in Form eines Targets enthält, mit mindestens einer Magnetvorrichtung im Targetrückseitenbereich, zur Erzeugung mindestens eines im Bereich der Kathodenoberfläche tunnelförmigen Magnetfeldes, welches an der Kathodenoberfläche an den Tunnelfusspunkten resultierende Pole bilden, wobei sich das tunnelförmige Feld in mindestens einen Teilbereich entlang einer Tunnellängsachse erstreckt.

Magnetfeldunterstützte Plasmaerzeugungsvorrichtungen sind weithin bekannt und benutzt, insbesondere werden solche verwendet als Zerstäubungsvorrichtung zur Aufbringung von dünnen Filmen auf Werkstücke (PVD). Solche Plasmaentladungen werden auch verwendet zur Abtragung von Material von Werkstücken, welches auch als Zerstäubungsätzen bezeichnet wird. Im Weiteren werden solche Plasmaentladungen auch eingesetzt in sogenannten PECVD-Verfahren, bei welchen unter Plasmaaktivierung aus der Gasphase chemisch eine Abscheidung von dünnen Schichten auf Werkstücke stattfindet. Auch sind Mischverfahren zwischen PVD und CVD Verfahren üblich. Besonders geeignet und verbreitet sind Plasmaerzeugungsvorrichtungen nach dem sogenannten Magnetronprinzip. Das Magnetronzerstäuben beispielsweise hat sich durchgesetzt wegen der hohen Zerstäubungsraten, die erzielbar sind und der einfachen Betriebsweise der Anordnung sowie der einfachen Steuerbarkeit. Die Quelle kann in jeder Lage und als Flächenquelle auf vielfältigste Art und Weise in vollautomatisierten Produktionsanlagen vorteilhaft eingesetzt werden. Eine solche Quelle besteht aus einer Kathode, die in einer Vakuumkammer auf negative Spannung gelegt wird, wobei durch ein vorhandenes Edelgas wie Argon oder auch ein Gemisch von Edelgasen mit Reaktivgasen eine Plasmaentladung unterhalten wird, wobei der dadurch auftretende Ionenbeschuss das Target zerstäubt und eine dünne Schicht abgeschieden werden kann. Um eine hohe Plasmadichte und somit auch eine hohe Zerstäubungsrate erzielen zu können, werden diese Plasmaentladungen mit Hilfe von Magnetfeldern konzentriert. Dies geschieht beispielsweise bei den Magnetronquellen durch Anordnen von Magnetfelderzeugungseinrichtungen auf der Kathoden- beziehungsweise Targetrückseite so, dass das Magnetfeld beispielsweise durch das Target ein- und austritt sodass ein tunnelförmiges Gebilde entsteht, welches auf der Targetvorderseite als Elektronenfalle für die Plasmaentladung wirkt. Die Wirkung wird weiter gesteigert, indem diese tunnelförmige Elektronenfalle ringförmig ausgebildet wird und auf der Targetvorderseite eine geschlossene Schlaufe bildet. Die Elektronenfalle wird dadurch sehr effizient. Eine solche Vorrichtung wird in der deutschen Patentschrift DE 24 17 288 beschrieben.

Die vorbeschriebene Ausführung einer Magnetronquelle hat den Nachteil, dass durch die schlauchförmige Ausbildung der Plasmaschlaufe eine grabenförmige Erosion des Targetmaterials entsteht. Dieses grabenförmige Erodieren führt zu einer sehr schlechten Ausnutzung des Targetmateriales im Bereich von etwa 20 bis 30 %. Gemäss der Deutschen Offenlegungsschrift DE-OS 27 07 144, welche wesentlichen Stand der Technik gegenüber der vorliegenden Erfindung bildet, wird nun vorgeschlagen, die magnetische Elektronenfalle und das Target relativ gegeneinander zu bewegen, um diesen Nachteil zu beheben. In der Beschreibung wird gezeigt, dass sowohl das Target über dem Magnetsystem bewegt werden kann, beispielsweise als rotierende Platte oder als rotierender Zylinder, oder aber auch das Magnetsystem unter dem Target bewegt werden kann. In beiden Fällen wird das Target gleichmässiger erodiert. Daselbe Ergebnis kann auch mit einem elektromagnetischen Wanderfeld erreicht werden. In beiden Fällen wird vorgeschlagen, immer die ganze Elektronenfalle beziehungsweise die Ringentladung relativ zum Target zu verschieben. Die Realisierung der elektromagnetischen Variante ist in der Praxis ausserordentlich aufwendig, da örtlich auf kleinem Raum hohe magnetische Flussdichten von einigen hundert Gauss erzeugt werden müssen. Die mechanische Bewegung des ganzen Magnetsystemes sowie des Targets ist ebenfalls recht aufwendig in der Realisation und führt zu grossen Baugrössen. Ein Beispiel, wo ein zylinderförmiges Target um ein feststehendes Magnetsystems rotiert, ist aus der Patentschrift US 4 356 073 ersichtlich. Die darin vorgestellte Lösung erfordert jedoch beim Aufbau des Magnetsystems, welches im Zylinder innen angeordnet ist, einen hohen konstruktiven Aufwand. Auch die Vakuum- und antriebstechnische Ausführung des rotierenden Targetzylinders ist konstruktiv sehr aufwendig.

Ein weiteres Beispiel einer verschiebbaren Magnetronelektronenfalle wird in der EP A 0 503 138 offenbart. Das Permanentmagnetsystem welches die Elektronenfalle für die Magnetronentladung erzeugt wird auf der Rückseite eines Targets, welches auf kathodischem Potential liegt, mit einem mechanischen Antrieb nach einem vorgegebenen Bewegungscharakteristikum bewegt, so dass das Sputtertarget homogener erodiert wird und dass beim reaktiven zerstäuben isolierende Belegungen auf der Targetoberfläche möglichst vermieden werden. Eine weitere Magnetronentladungsanordnung offenbart die EP A 0 065 277. Auch hier wird das ganze Magnetsystem, welches die Magnetronelektronenfalle erzeugt mechanisch über einen Motorantrieb auf der Rückseite einer Kathode hin und her bewegt. Die Vorrichtung wird eingesetzt zum chemisch reaktiven ätzen von Substraten. Zur Erhöhung der Reaktivität der beteiligten Reaktivgase wird eine bewegbare Magnetronentladung verwendet.

Die vorliegende Erfindung hat sich nun zur Aufgabe gemacht, die Nachteile des Standes der Technik zu beheben. Insbesondere soll eine Plasmaentladungsvorrichtung realisiert werden, welche es erlaubt, eine Plasmaentladung in vorgegebenen Bereichen über eine Kathodenfläche gesteuert zu führen, welche beispielsweise bei einer Zerstäubungs- oder Aetzeinrichtung zu einem vorgegebenen beziehungsweise gleichförmigen Targetabtrag führt, bei kompaktem und wirtschaftlichem Aufbau.

Diese Aufgabe wird erfindungsgemäss mit der im kennzeichnenden Teil des Anspruchs 1 angegebenen Lehre gelöst. Es ist vorteilhaft, bei Magnetronentladungen, bei welchen mindestens ein Teil der Plasmaschlaufe längs gestreckt ist nicht die ganze Elektronenfalle zu bewegen. Es genügt, wenn nur ein geradliniger Teil der Elektronenfalle verschoben wird. Weiterhin ist es vorteilhaft, wenn von dem geradlinigen Teil nur eine Seite des Tunnelfusspunktpoles bewegt wird. Als Tunnelfusspunktpol wird der resultierende magnetische Pol bezeichnet, der an der Kathodenoberfläche durch das tunnelförmige Magnetfeld erzeugt wird. Ein Magnetfeldtunnel bildet an der Kathodenoberfläche immer einen Eintritts- und einen Austrittspol. Besonders einfach und wirkungsvoll ist die Anordnung, wenn eine einzelne Ringentladung verwendet wird, wobei nur deren mittlerer Tunnelfusspol verschoben wird. Durch gesteuertes Verschieben des geraden Teilbereichs dieses mittleren Fusspunktpoles beispielsweise durch periodisches Hin- und Herführen, wird sowohl die mittlere Lage wie auch die Breite der Plasmaentladung über dem Target verändert. Dies führt beispielsweise bei einer Zerstäubungsentladung zu einer gleichförmigeren Erosion der Targetoberfläche. Ein weiterer Vorteil der erfindunsgemässen Anordnung erlaubt die Vermeidung von Zonen am Target, die nicht durch das Plasma überstrichen werden. Dies ist besonders wichtig bei reaktiven Verfahren, insbesondere beim Zerstäuben von dielektrischen Materialien für optische Schichten, insbesondere für optische Mehrfachschichten. Selbstverständlich kann die Anordnung auch mit mehr als einer Ringentladung, das heisst mit mehreren Plasmaentladungsringen grossflächig aufgebaut werden, wo dann mehrere geradlinige Tunnelfusspunkte verschoben werden können.

Wie gesagt können magnetfeldgestützte Plasmaerzeugungsvorrichtungen auch ohne geschlossene Magnetfeldtunnelschlaufen, beziehungsweise Plasmaschlaufen ausgebildet sein. In diesem Fall wird allerdings die Elektronenfallenwirkung verringert und die Plasmaentladung muss mit höheren Spannungen betrieben werden. Ausserdem sinkt die maximal mögliche Entladungsleistung, beziehungsweise die Plasmadichte. Es ist somit besonders vorteilhaft, eine Magnetfelderzeugungsvorrichtung zu verwenden, welche eine Plasmaentladung mit geschlossener Plasmaschlaufe bestimmt.

In diesem Fall kann die erfindungsgemässe Ausführung besonders einfach realisiert werden. Beispielsweise kann ein äusserer Rahmen verwendet werden, bestehend aus Permanentmagneten, der eine erste Magnetpolerzeugungsvorrichtung darstellt und der eine zweite Magnetpolerzeugungsvorrichtung umschliesst, sodass zwischen der ersten und der zweiten Magnetpolerzeugungsvorrichtung ein tunnelförmiges Magnetfeld entsteht. Bei einer langgezogenen planaren Anordnung, wie diese in der praktischen Anwendung oft benötigt wird, kann dann erfindungsgemäss der innere, beziehungsweise zweite Magnetpol quer zur Kathodenlängsausdehnung entlang der planaren Fläche bewegt werden. Durch beispielsweise periodisches Hin- und Herbewegen des zugehörigen Tunnelfusspunktpoles wird auch die Plasmaentladung folgen und somit beispielsweise bei einer Zerstäubungsbeziehungsweise Aetzvorrichtung zu einem grossflächigeren, gleichförmigeren Abtrag der Kathoden beziehungsweise Targetoberfläche führen. Die Anordnung wird besonders einfach, weil erfindungsgemäss nur das geradlinige Stück des Tunnelfusspunktpoles bewegt werden muss. Die komplizierten Entladungsverhältnisse der Mangetronringentladung können somit besser beherrscht werden, als wenn die ganze ringförmige Elektronenfallenkonfiguration verändert werden muss. Selbstverständlich können mit der erfindungsgemässen Anordnung auch mehrere Ringentladungen betrieben werden, wobei dann innerhalb des feststehenden, rahmenförmigen Magnetrahmens mehrere geradlinige Tunnelfusspunktpole erzeugt werden, die bewegt werden können. Die Bewegung der Tunnelfusspunktpole kann auch gesteuert nach einem bestimmten Profil erfolgen, was erlaubt, ein bestimmtes mittleres Verteilungsprofil der Plasmadichte zu erzeugen. Dies führt beispielsweise bei einer Zerstäubungsvorrichtung dazu, dass die Targeterosionsausbildung im wesentlichen auf gewünschte Art und Weise vorbestimmt werden kann. Ausserdem kann damit auch leichter die Verteilungscharakteristik der abgestäubten Materialteilchen definiert, beziehungsweise festgelegt werden. Die erfindungsgemässe Anordnung kann einfach und wirtschaftlich aufgebaut werden, wenn für die Magnetfelderzeugungsvorrichtung Permanentmagnete verwendet werden, wobei ein Teil der Magnetvorrichtung, die den längsgestreckten Tunnelfusspunktpol bildet, mechanisch bewegt, beispielsweise verschoben wird. Möglich ist dies aber auch durch Verwendung von elektromagnetischen Anordnungen oder auch Kombinationen von solchen mit Permanentmagneten.

In der praktischen Ausführung treten aber bei linear parallel verschieblichen Magnetpaketen grössere mechanische Kräfte auf, die nicht einfach zu beherrschen sind und einen gewissen Aufwand erfordern bei der Lagerung des Systems wie auch auf der Antriebsseite. Eine vorteilhafte und bevorzugte Lösung dieses Problems ergibt sich durch die weitere Ausbildung der Erfindung indem längsgestreckte magnetpolbildende Pakete in der Längsachse drehbar gelagert werden. Diese drehbare Lagerung kann die entstehenden und unterschiedlichen Kräfte beherrschen, wobei der Realisierungsaufwand entsprechend gering ist. Auch die dafür notwendige Antriebsleistung ist sehr gering und bewegt sich im Bereich von einigen Watt bis einer Grössenordnung von etwa 100 Watt der Antriebsmotorenleistung, je nach Grösse der Plasmaerzeugungsvorrichtung. Bei einer Kathodenbaulände von ca. 45cm reicht eine Antriebsleistung von etwa 100 Watt ohne weiteres aus. Bei grösseren Anordnungen sind entsprechend grössere Antriebsdimensionierungen notwendig. Eine sehr geeignete Anordnung weist beispielsweise einen äusseren feststehenden Permanentmagnetpolrahmen auf, wobei dieser zwei drehbar gelagerte geradlinige Magnetpolzeilen umschliesst. Die Pole sind dann in einer Ausgangslage an der targetzugewandten Seite auf einer Längsseite des äusseren Rahmens mit dem drehbaren benachbarten Pol gleichnamig angeordnet, wobei auf der gegenüberliegenden Seite der drehbar gelagerte zweite Pol gegenpolig angeordnet ist. Um ein Unterbrechen des Plasmas zu vermeiden, müssen nun die drehbaren Pole gleichförmig so gegeneinander gedreht werden, dass nach 90° Drehung die Pole in der Mittelachse der Anordung gleichförmig gegeneinander stehen. Nach einer weiteren 90° Drehung haben die drehbaren Pole ihre Seite gewechselt. Der an der Targetoberfläche entstandene resultierende Tunnelfusspunktpol ist nun von einer Seite auf die andere Seite gewandert, wobei der äussere Tunnelfusspunktpol durch den äusseren Polrahmen und den einen drehbaren Magnetpol positionsabhängig gebildet wird. Nach einer 180° Drehung wechselt die Situation auf die andere Seite. Um eine gleichförmige Bewegung, beziehungsweise Breitenmodulierung der Tunnelfusspunktpole ohne Unterbrechung der Plasmaentladung zu erreichen, werden die Magnete wieder um 180° zurückgedreht. Mit einer solchen Anordnung können nun bei Zerstäubungsvorrichtungen ohne weiteres Targetausnutzungsgrade bis in den Bereich von 70% und mehr erreicht werden.

Der mechanische Aufbau kann weiter vereinfacht werden, wenn ein kontinuierlich drehender Motorantrieb verwendet wird, unter Zwischenschaltung eines sogenannten Pendelgetriebes, welches dafür sorgt, dass die drehbaren Magnetzeilen um 180° hin und her pendeln. Als Antriebsvorrichtung sind Motoren jeglicher bekannter Art verwendbar, wie beispielsweise Elektromotoren, Hydromotoren, pneumatische Motoren, u.a. Wenn grossflächige Kathoden vorgesehen sind, können ohne weiteres mehrere drehbare Magnetpolerzeugungsvorrichtungen vorgesehen werden. Die drehbaren Magnetpolerzeugungsvorrichtungen können nicht nur kontinuierlich hin und her bewegt werden, um eine Art Wobbelung der Plasmaentladung im Bereich der Kathodenoberfläche zu erzeugen, sie können auch so gezielt angesteuert und bewegt werden, dass die tunnelförmige Elektronenfalle in ihrer Wirkung örtlich stark verschlechtert wird, was zu einem Auslöschen des zugehörigen Plasmaringes führt, beziehungsweise zu einer Bevorzugung der zugehörigen Plasmaringentladung. Somit ist es möglich, gezielt einzelne Plasmaringe über einer Kathodenfläche gesteuert ein- und auszuschalten dass heisst, beispielsweise die Kathodenoberfläche durch örtliche Plazierung der Ringentladung abzutasten.

Im weiteren ist es möglich, nicht nur die Position der Plasmaentladung mit Hilfe der vorliegenden Erfindung in Zeitabschnitten vorzugeben, sondern auch zusätzlich die Entladungsleistung synchron nach vorgegebenen Werten an verschiedenen Positionen der Plasmaentladung nachzuführen. Dies kann beispielsweise mit einer Stromversorgung realisiert werden, bei welcher die Entladungsleistung mit einer Steuerung nachgeführt werden kann. Auch ist diese Modulation im Extremfall sogar pulsgesteuert möglich. Eine Pulssteuerung hat beispielsweise den zusätzlichen Vorteil, dass beim Zerstäuben von dielektrischen Materialien mit einem Reaktivprozess unerwünschte Ueberschläge weitestgehend vermieden werden können, beziehungsweise die Entladung stabil beherrscht werden kann. Die Kombination von örtlich varierbarer Plasmaentladung mit modulierbarer Stromversorgung ermöglicht eine zusätzliche Beeinflussung beziehungsweise Steuerung der Abtragcharakteristik, beziehungsweise der Verteilungscharakteristik des abgestäubten Materiales.

Ausführungsbeispiele der Erfindung werden nun anhand von Zeichnungen näher erläutert, es zeigt:

Figur 1 schematisch eine Kathodenanordnung für eine Zerstäubungsquelle mit verschiebbarer Gesamtelektronenfalle gemäss Stand der Technik in Querschnittdarstellung.

Figur 2 eine erste erfindungsgemässe Anordnung schematisch und im Querschnitt.

Figur 3 beispielsweise eine zweite erfindungsgemässe Anordung im Querschnitt.

Figur 3a-c schematisch und im Querschnitt verschiedene vorteilhafte Positionen der Magnetanordnung gemäss Figur 3.

Figur 4a-c schematisch und im Längsschnitt ein weiteres Ausführungsbeispiel für eine Anordnung der Magnetpolerzeugungsvorrichtungen für mehrere verschiebbare Plasmaringe.

Figur 4d die schematische Draufsicht der Anordnung gemäss den Figuren 4a-c.

Die Figuren zeigen schematisch und beispielsweise verschiedene Ausführungsformen von Plasmaerzeugungsvorrichtungen, wobei die dargestellten Beispiele Zerstäubungsvorrichtungen darstellen. Dieselbe Funktionsweise kann aber, wie bereits erwähnt, auch in einer Aetzvorrichtung verwendet werden. In so einem Fall wird anstelle eines Zerstäubungstargets das Substrat plaziert, welches dann mit der Plasmaentladung durch Zerstäuben oder auch durch reaktive Prozesse bearbeitet wird.

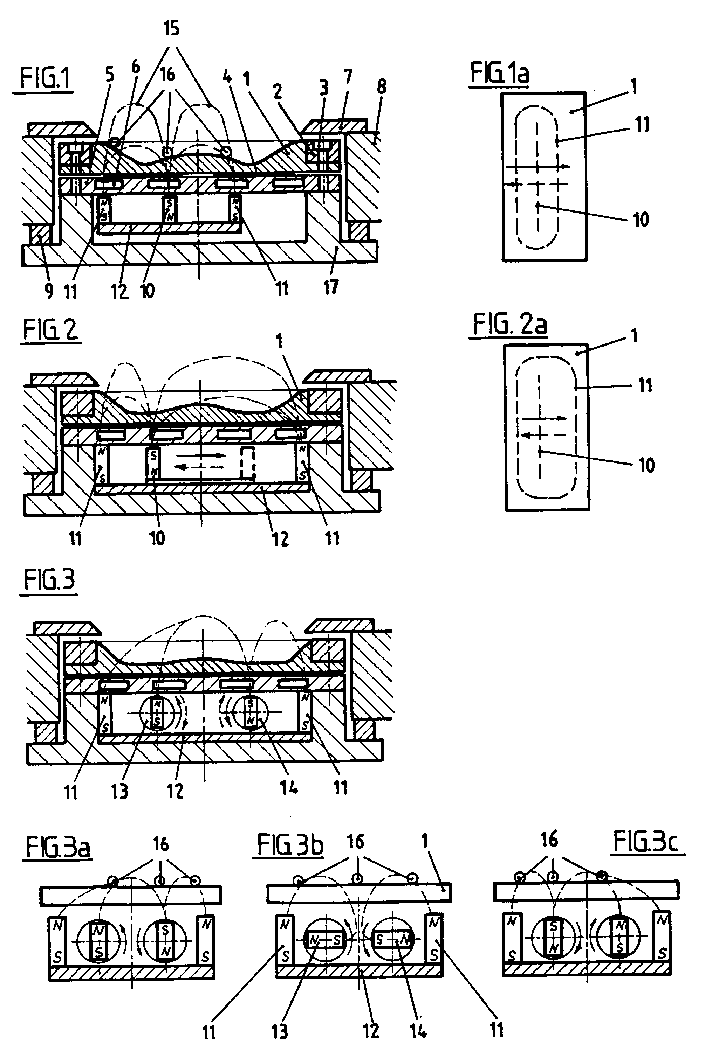

Figur 1 zeigt eine sogenannte Magnetronzerstäubungsvorrichtung gemäss Stand der Technik. Der Kathodenkörper bestehend aus einem Gehäuse 17, einer Kühlplatte 5 mit Kühlkanälen 6 und einem Target 1 ist über eine dichtende Isolation 9 an eine Vakuumkammer 8 angeflanscht. Das Zerstäubungstarget 1 wird durch einen Halterahmen 2 mit Schrauben 3 über eine Kontaktfolie 4 an die Kühlplatte 5 angepresst. An der Vakuumkammer ist zusätzlich eine Abschirmung 7, welche gleichzeitig eine Anode bildet, peripher die Kathodenanordnung umfassend angeordnet. Die ganze Anordnung ist beispielsweise rechteckförmig ausgebildet, wobei das Target beispielsweise typische Abmessungen von etwa 145 x 450 mm aufweist. Hinter der Kühlplatte 5 ist ein Magnetsystem angeordnet, bestehend aus einem äusseren Permanentmagnetrahmen 11, welcher einen zentralen Magneten 10 umschliesst, der für den äusseren Rahmen einen Gegenpol bildet. Die Magnete sind so angeordnet, dass sie ein tunnelförmiges Feld 15 erzeugen, welches durch die Kühlplatte 5 und das Target 1 hindurchtritt, und somit eine ringförmige Elektronenfalle vor der Targetoberfläche bildet. Das Magnetsystem ist rückseitig mit einer Polplatte 12 aus ferromagnetischem Material versehen, um den rückseitigen Feldfluss zu schliessen. Die Magnetpolerzeugungsvorrichtung 10, 11, 12, beziehungsweise das Magnetsystem ist so ausgebildet, dass durch das tunnelförmige Feld 15 auf der Targetoberfläche beim Ein- und Austritt der Feldlinien Tunnelfusspunktpole 16 resultieren. Die Magnetpolerzeugungsvorrichtungen 10, 11, 12 können auf verschiedenste Art und Weise aufgebaut werden, wobei massgebend ist, dass wie erwähnt an der Targetoberfläche ein tunnelförmiges Magnetfeld 15 ringförmig ausgebildet ist, mit entsprechenden resultierenden Tunnelfusspunktpolen 16 an der Targetoberfläche. Zur Erzeugung einer Plasmaentladung wird an den Kathodenkörper 17, beziehungsweise an das Target 1, beispielsweise eine negative Spannung von einigen hundert Volt gegenüber der Anode 7 angelegt. Die Kathode kann in bekannter Weise auch mit einer AC-Stromversorgung betrieben werden im Bereich von einigen 100 Hz bis kHz, Mittelfrequenz und Hochfrequenz. Auch Kombinationen beziehungsweise Ueberlagerungen von AC und DC Versorgungen sind möglich. Ausserdem sind Zusatzelektroden in den üblichen Bias-Aordnungen verwendbar. Die Vakuumkammer ist dabei auf einen Argongasdruck von etwa 10⁻² bis 10⁻³ Millibar eingestellt. Aus der über dem Target entstandenen ringförmigen Plasmaentladung werden Ionen gegen das Target 1 beschleunigt, welche einen ringförmigen Graben erodieren. Zur Behebung dieses Nachteils wird vorgeschlagen, wie in Figur 1 gezeigt, die Magnetpolerzeugungsvorrichtungen 10, 11, 12 als Ganzes zu verschieben. Dieses Verschieben der ganzen Elektonenfalle hat auch eine Verschiebung des Plasmaringes zur Folge. Somit wird das Target 1, wie dies in Figur 1 dargestellt ist, einigermassen gleichförmig erodiert. Die für die Bewegung eines solchen Magnetsystems 10, 11, 12 erforderlichen Antriebsmittel und Lagerungsmittel sind recht aufwendig in der Realisierung. Die daraus erforderlichen Baugrössen sind in der Anwendung behindernd und einschränkend. Ausserdem treten im Umlenkbereich des Plasmaschlauches Ueberschneidungen auf, welche die Targeterosion an bestimmten Orten im Bereich der Targetendzonen bevorzugt und ungünstig hervortreten lassen. Dies schränkt die maximale Ausnutzung eines Targets entsprechend ein, da in diesen Bereichen das Target durcherodiert wird bevor der grossflächige, langgezogene Targetnutzbereich fertig erodiert werden kann. Da das Plasma die gesamte Targetfläche in bestimmten Bereichen nur temporär belegt, können bei Reaktivprozessen, insbesondere beim Zerstäuben von dielektrischen Materialien Nachteile in Bezug auf unerwünschte Lichtbogenentladungen und Entladungsinstabilitäten auftreten. Die Einstellung eines erwünschten Erosionsprofiles ist überdies nur begrenzt möglich. Solche Anordnungen können, wie dies im Stand der Technik bekannt ist, auch in anderen Kathodengeometrien wie beispielsweise röhrenförmigen Anordnungen auf vielfältige Weise eingesetzt werden. Figur 1a zeigt schematisch in der Aufsicht wie die gestrichelt gezeichnete Magnetvorrichtung 10, 11 unter einem Target 1 gemäss der Pfeilrichtung hin und her bewegt werden kann.

In Figur 2 wird schematisch und beispielsweise in einer Querschnittsdarstellung eine erste Variante einer erfindungsgemässen Lösung dargestellt. Die erste Magnetpolerzeugungsvorrichtung 11 ist als Rahmen ausgebildet, der gegenüber dem Target 1 fest steht. Eine zweite Magnetpolerzeugungsvorrichtung 10 ist querverschieblich zur Kathodenlängsachse innerhalb der sie umfassenden ersten Magnetpolerzeugungsvorrichtung 11 angeordnet. Zur Verdeutlichung ist dies auch in Figur 2a in der Aufsicht dargestellt. Die Auslenkamplitude der Hin- und Herbewegung der zweiten Magnetpolerzeugungsvorrichtung 10 wird so gewählt, dass das gewünschte Erosionsprofil am Target 1 entsteht. Dies kann durch einfache Versuche jeweils ermittelt werden. Die Auslenkamplitude darf aber nur soweit erfolgen, dass die Tunnelfusspunktpole 16 an der Targetoberfläche 1 nicht verschwinden, beziehungsweise, dass die tunnelförmige Elektronenfalle 15 an der Targetoberfläche nicht verschwindet und somit die Plasmaentladung verunmöglichen würde. Dieser Effekt kann in gewissen Fällen, wenn erwünscht, auch gezielt genutzt werden, um die Plasmaentladung abzuschalten. Die Bewegung der zweiten Magnetpolerzeugungsvorrichtung 10 kann mit bekannten motorischen Antriebsmitteln erfolgen. Besonders vorteilhaft ist in der praktischen Ausführung die Verwendung eines Pendelgetriebes, das zwischen die Magnetpolerzeugungsvorrichtung 10 und den Antriebmotor geschaltet wird. Es ist aber auch möglich, ohne Zwischenschaltung eines solchen Pendelgetriebes eine gesteuerte Bewegung unter Zuhilfenahme einer Motorsteuerung vorzunehmen.

Eine bevorzugte Ausführungsvariante der Erfindung wird in Figur 3 im Querschnitt schematisch dargestellt. Innerhalb der ersten rahmenförmigen Magnetpolerzeugungsvorrichtung 11 befinden sich zwei um ihre Längsachse drehbar angeordnete Permanentmagnetanordnungen 13 und 14. Die Magnete sind so angeordnet, dass diese in bekannter Weise tunnelförmige Magnetfelder über der Targetoberfläche erzeugen können. Dazu müssen die paarweise angeordneten Permanentmagnete 13, 14 auch mit einem genügenden Abstand gegenüber der Polrückschlussplatte 12 versehen werden. Figur 3a zeigt eine erste Ausgangslage der drehbaren Permanentmagnete 13, 14. Der linke drehbare Magnet 13 ist so eingestellt, dass sein Pol an der targetnahen Seite gleichnamig ist mit dem Pol des Magnetrahmens 11. Der rechte drehbare Magnet 14 ist gegenpolig angeordnet. Somit wird einerseits ein tunnelförmiges Feld 15 gebildet zwischen den Magneten 14 und 13 und 11, andererseits auf der rechten Seite zwischen den Magneten 14 und 11. Werden nun die Magnete 13 und 14 um 90° gleichsinnig verdreht, laufen die Pole der Magnete gleichpolig gegeneinander. Die dipolbildenden Magnete 13 und 14 sind nun, wie Figur 3b zeigt, parallel zur Targetplatte 1 ausgerichtet. Die beiden gegeneinander weisenden und sich abstossenden Pole der Magnete 13 und 14 erzeugen in dieser Position einen resultierenden Tunnelfusspunktpol 16 im Zentrum der Targetoberfläche. Dieser Tunnelfusspunktpol ist somit von rechts nach links gewandert. Damit ist auch die Position des Plasmas und die Breite der Entladung über dem Target verschoben worden. Die vom Zentrum abgewandten Pole der Magnete 13 und 14 sind nun gleichnamig mit den targetzugewandten Polen der rahmenförmigen Magnetpolerzeugungsvorrichtung 11. Eine weitere Drehung der Magnete 13, 14 um 90° zeigt Figur 3c. Diese weitere Drehung der Magnete 13, 14 verschiebt die Tunnelfusspunktpole 16 und somit auch die Plasmaentladung weiter auf die linke Seite des Targets. Die Drehrichtung der Magnete 13 und 14 muss stets so gewählt werden, dass die targetnahen Pole der Magnete 13, 14 gegenüber dem targetnahen Pol des Rahmenmagneten 11 im äusseren Zwischenbereich der Magnete 11, 14 oder 11, 13 nie wechselpolig im targetnahen Bereich aufeinander zulaufen sodass ein tunnelförmiges Feld unterbrochen wird und die Elektronenfalle zerstört würde. Wenn ein kontinuierlicher Betrieb der Entladung gewünscht wird, ist auf diesen Punkt zu achten. In gewissen Fällen kann aber ein gezieltes Verdrehen und Zerstören der Elektronenfalle beabsichtigt sein, um das Plasma zu unterbrechen. Mit Hilfe eines gesteuerten Antriebes können die Magnete 13, 14 leicht so bewegt weden, dass ein bestimmtes Erosionsprofil erreicht werden kann. Besonders geeignet zur Vereinfachung der Anordnung ist wiederum die Zwischenschaltung eines Pendelgetriebes zwischen Motorantrieb und den Magneten 13, 14. Dadurch kann auf eine Steuerung des Antriebes verzichtet werden, was die Anordnung weiter vereinfacht. Die vorgeschlagene Ausführung kann selbstverständlich auch beispielsweise in rohrförmigen Kathodenanordnungen verwendet werden.

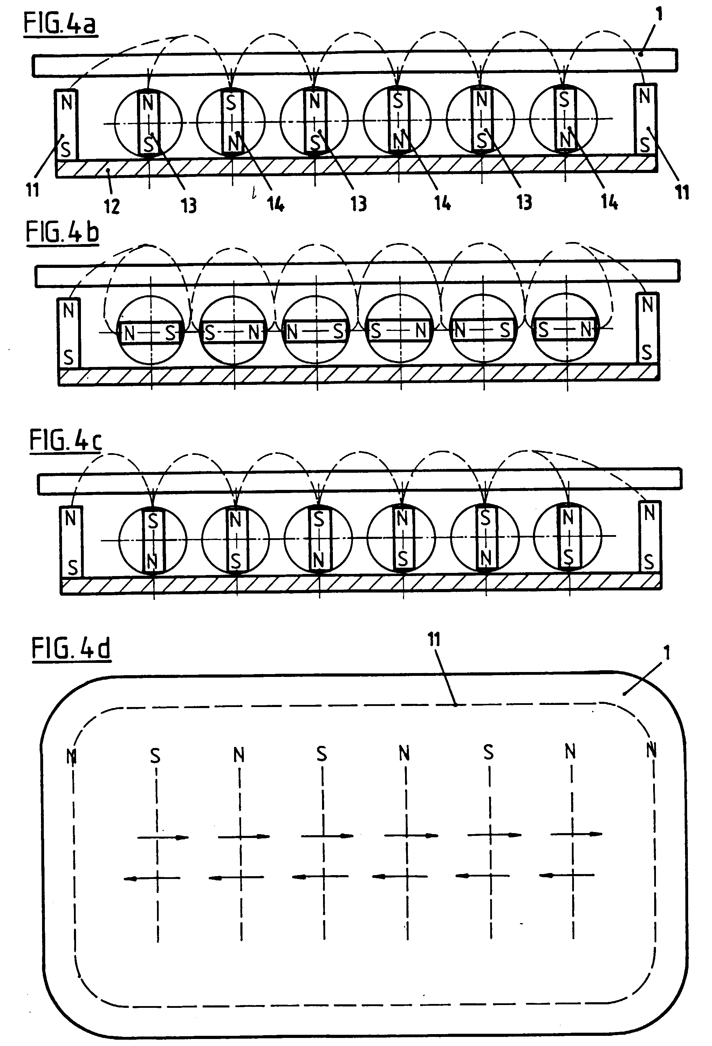

Figur 4 a-c zeigt schematisch und im Schnitt eine erfindungsgemässe Anordnung, wenn das Prinzip nach Figur 3 auf eine grossflächige Anordnung angewendet werden soll. Werden beispielsweise 3 drehbare Magnetpolpaare 13, 14 verwendet, können 3 Plasmaschlaufen erzeugt werden, welche über das Target 1 gesteuert bewegt werden können. Die Plasmaschlaufen können aber auch wahlweise sequenziell ein- und ausgeschaltet werden, indem ein oder mehrere drehbare Magnetpole so weggeschwenkt werden, dass die Elektronenfallenwirkung entsprechend an der gewünschten Position verhindert wird. Figur 4d zeigt schematisch eine Aufsicht der grossflächigen Anordnung mit mehrfachen, bewegbaren Tunnelfusspunktpolen.

## Patentansprüche

1. Magnetronplasmaerzeugungsvorrichtung zur Behandlung von Substraten in einer Vakuumkammer mit einer Kathode (17,5,2,1), die an ihrer Oberfläche das zu bearbeitende Material in Form eines Targets (1) enthält, mit mindestens einer Magnetvorrichtung (10,11,12) im Targetrückseitenbereich zur Erzeugung mindestens eines im Bereich der Kathodenoberfläche tunnelförmigen Magnetfeldes (15) welches an der Kathodenoberfläche Tunnelfusspunktpole (16) bildet, wobei sich das tunnelförmige Feld (15) in mindestens einen Teilbereich entlang einer Tunnellängsachse erstreckt, dadurch gekennzeichnet, dass die Magnetvorrichtung (10,11,12) eine örtlich feststehende erste Magnetpolerzeugungsvorrichtung (11) umfasst und als geschlossener Rahmen mindestens eine zweite Magnetpolerzeugungsvorrichtung (10) umschliesst, welche Mittel aufweist zum verschieben ihres zugehörigen Tunnelfusspunktpoles (16) quer zur Tunnellängsachse.

2. Magnetronplasmaerzeugungsvorrichtung nach Anspruch 1, dadurch gekennzeichnet, dass mindestens die zweite Magnetpolerzeugungsvorrichtung (10) verschieblich angeordnet ist.

3. Magnetronplasmaerzeugungsvorrichtung nach Anspruch 1, dadurch gekennzeichnet, dass die zweite Magnetpolerzeugungsvorrichtung aus paarweise angeordneten Permanentmagneten (13,14) besteht und in ihrer Längsachse parallel zum Target (1) drehbar so angeordnet sind, dass im Bereich der Kathodenoberfläche ein tunnelförmiges, querveränderliches Magnetfeld entsteht.

4. Magnetronplasmaerzeugungsvorrichtung nach Anspruch 3, dadurch gekennzeichnet, dass die Pole der Magnete (11,12,13) in ihrer Ausgangslage gegenüber der Targetnahen Position wechselpolig angeordnet sind, wobei jeweils ein Randpolpaar (11,13; 11,12) mit dem Aussenrahmen (11) gleichpolig angeordnet ist.

5. Magnetronplasmaerzeugungsvorrichtung nach Anspruch 4, dadurch gekennzeichnet, dass das Magnetpoolpaar (12,13) mit ihren Polen gegeneinander um 180° drehbar so gelagert ist, dass in der Mittelstellung deren Pole gleichnamig und abstossend sind.

6. Magnetronplasmaerzeugungsvorrichtung nach Anspruch 5, dadurch gekennzeichnet, dass das Magnetpolpaar (12,13) mit einer Pendelantriebsvorrichtung gekoppelt ist.

7. Magnetronplasmaerzeugungsvorrichtung nach Anspruch 6, dadurch gekennzeichnet, dass die Pendelantriebsvorrichtung aus einem Pendelgetriebe und einem Motorenantrieb besteht.

8. Magnetronplasmaerzeugungsvorrichtung nach einem der vorhergehenden Ansprüche 3 bis 7, dadurch gekennzeichnet, dass mehrere drehbare Magnetpolerzeugungsvorrichtungspaare (12,13) vorgesehen sind.

9. Magnetronplasmaerzeugungsvorrichtung nach Anspruch 8, dadurch gekennzeichnet, dass eine Antriebssteuerung vorgesehen ist für die Magnetpolerzeugungsvorrichtungspaare (12,13) zur gesteuerten Querbewegung der geradlinigen Teilbereiche des tunnelförmigen Magnetfeldes (16) nach vorgegebenem Bewegungsprofil, wie beispielsweise kontinuierliches Rotieren oder Hin und Herbewegen.

10. Magnetronplasmaerzeugungsvorrichtung nach Anspruch 8 oder 9, dadurch gekennzeichnet, dass eine Antriebssteuerung für die Magnetpolerzeugungsvorrichtung (12,13) vorgesehen ist, zur gezielten sequentiellen Ein- und Ausschaltung der tunnelförmigen Magnetfeldteilbereiche zur sequentiellen Ein- und Ausschaltung der Plasmaentladung in verschiedenen Bereichen der Targetoberfläche.

11. Magnetronplasmaerzeugungsvorrichtung nach einem der vorhergehenden Ansprüche, dadurch gekennzeichnet, dass eine Leistungsmodulierbare bzw. eine pulssteuerbare Stromversorgung mit der Plasmaerzeugungsvorrichtung und derer Magnetfeldbewegungseinrichtung synchronisierbar gekoppelt ist.

12. Magnetronplasmaerzeugungsvorrichtung nach einem der vorhergehenden Ansprüche, dadurch gekennzeichnet, dass diese eine Zerstäubungsvorrichtung und/oder eine Aetzvorrichtung und/oder eine Plasma CVD Vorrichtung ist.

## Claims

1. A magnetron plasma generating device to treat substrates in a vacuum chamber comprising a cathode (17,5,2,1) which at its upper surface contains the material to be treated in form of a target (1) and comprising at least one magnet device (10,11,12) at the back side of the target to generate in the area of the cathode surface at least one tunnel-like magnet field (15) which forms tunnel foot poles (16) on the cathode surface whereby the tunnel-like field (15) extends at least along a part of a longitudinal tunnel axis, characterized in that the magnetic device (10,11,12) contains a locally fixed first magnet pole generating device (11) and surrounds as a closed frame at least a second magnet pole generating device (10) which comprises means for displacing the corresponding tunnel foot pole (16) laterally to the tunnel axis.

2. A magnetron plasma generating device according to claim 1, wherein at least the second magnet pole generating device (10) is placed as a movable arrangement.

3. A magnetron plasma generating device according to claim 1, wherein the second magnet pole generating device consists of pairs of permanent magnets (13,14) which are placed on their longitudinal axes parallely pivotable to the target (1) such that in the area of the cathode surface a tunnel-like laterally modifiable magnetic field is generated.

4. A magnetron plasma generating device according to claim 3, wherein the poles of the magnets (11,12,13) in their starting position close to the target are arranged in alternating polarity whereas an edge pole pair (11,13; 11,12) is placed homopolarly with the outer frame (11).

5. A magnetron plasma generating device according to claim 4, wherein the magnet pole pair (12,13) is pivotable by 180° with its poles oppositely oriented so that in the middle position the poles are equal and repulsive.

6. A magnetron plasma generating device according to claim 5, wherein the magnet pole pair (12,13) is coupled with a pendulum drive device.

7. A magnetron plasma generating device according to claim 6, wherein the pendulum drive device consists of a pendulum gear unit and a motor drive.

8. A magnetron plasma generating device according to any of claims 3 to 7 , wherein several pairs of pivotable magnet pole generating devices (12,13) are provided.

9. A magnetron plasma generating device according to claim 8, wherein a drive control is intended for the magnet pole generating device pairs (12,13) for a controlled lateral movement of the rectilinear partial areas of the tunnel-like magnet field (16) according to a predetermined moving profile as for instance continuous rotation or a forward and backwards movement.

10. A magnetron plasma generating device according to claim 8, wherein a drive control is used for the magnet pole generating device pairs (12,13) for a defined sequential on and off switching of the tunnel-like partial areas of the magnetic field for a sequential on and off switching of the plasma discharge in different areas of the target surface.

11. A magnetron plasma generating device according to any of claims 1 to 10, wherein a power modulatable or a pulsable power supply is synchronously coupled with the plasma generating device trough the device for moving the magnetic field.

12. A magnetron plasma generating device accroding to any of claims 1 to 11, wherein the device is a sputtering device and/or an etching device and/or a plasma CVD device.

## Revendications

1. Dispositif de magnétron producteur de plasma pour le traitement de substrats dans une chambre à vide, du type comportant une cathode (17, 5, 2, 1), qui comporte en surface la matière à traiter sous la forme d'une cible (1) et, du côté arrière de la cible, un dispositif à aimants (10, 11, 12) pour produire au voisinage de la surface de la cathode au moins un champ magnétique (15) en forme de tunnel, qui forme des pôles (16) de pied de tunnel sur la surface de la cathode, le champ en forme de tunnel (15) s'étendant au moins sur une zone partielle le long d'un axe longitudinal de tunnel, caractérisé en ce que le dispositif à aimants (10, 11, 12) comprend un premier dispositif de production de pôles magnétiques (11) situé en position fixe et entoure, en formant un cadre fermé, au moins un deuxième dispositif de production de pôles magnétiques (10), lequel présente des moyens pour déplacer son pôle de pied de tunnel (16) transversalement par rapport à l'axe longitudinal de tunnel.

2. Dispositif de magnétron producteur de plasma selon la revendication 1, caractérisé en ce qu'au moins le deuxième dispositif de production de pôles magnétiques (10) est assorti d'une possibilité de déplacement.

3. Dispositif de production de plasma pour magnétron selon la revendication 1, caractérisé en ce que le deuxième dispositif de production de pôles magnétiques est constitué d'aimants permanents (13, 14) qui sont groupés par paires et qui sont rotatifs sur leur axe longitudinal parallèlement à la cible (1), de telle manière qu'au voisinage de la surface de la cathode, il se crée un champ magnétique en forme de tunnel pouvant être modifié transversalement.

4. Dispositif de magnétron producteur de plasma suivant la revendication 3, caractérisé en ce que, dans leur disposition de départ, les pôles des aimants (11, 13, 14) sont montés avec capacité d'alternance des pôles par rapport à la position proche de la cible, une paire de pôles de bord (11, 13 ; 11, 14) présentant toujours la même orientation polaire que le cadre extérieur (11).

5. Dispositif de magnétron producteur de plasma selon la revendication 4, caractérisé en ce que ladite paire de pôles magnétiques (13, 14) est montée avec ses pôles à rotation relative de 180 degrés de telle manière qu'au milieu, les pôles soient de même type et en répulsion.

6. Dispositif de magnétron producteur de plasma selon la revendication 5, caractérisé en ce que ladite paire de pôles magnétiques (13, 14) est couplée avec un dispositif à commande oscillante.

7. Dispositif de magnétron producteur de plasma selon la revendication 6, caractérisé en ce que le dispositif à commande oscillante est constitué d'une commande oscillante et d'un entraînement par moteur.

8. Dispositif de magnétron producteur de plasma selon l'une quelconque des revendications 3 à 7, caractérisé en ce qu'il est prévu plusieurs paires de dispositifs de production de pôles magnétiques à rotation (13, 14).

9. Dispositif de magnétron producteur de plasma selon la revendication 8, caractérisé en ce qu'il comporte des moyens de commande d'entraînement des paires de dispositifs de production de pôles magnétiques (13, 14), pour assurer le déplacement transversal commandé de ladite zone partielle linéaire du champ magnétique (15) en forme de tunnel selon un profil de déplacement prédéterminé, comme, par exemple, une rotation continue ou un mouvement de va-et-vient.

10. Dispositif de magnétron producteur de plasma selon l'une des revendications 8 ou 9, caractérisé en ce qu'il est prévu des moyens de commande d'entraînement du dispositif de production de pôles magnétiques (13, 14) pour assurer en séquences désirées la mise en oeuvre et la suppression des zones partielles de champ magnétique en forme de tunnel, afin de mettre en oeuvre et supprimer séquentiellement la décharge de plasma dans différentes zones de la surface de la cible.

11. Dispositif de magnétron producteur de plasma selon l'une quelconque des revendications précédentes, caractérisé en ce qu'une alimentation en courant, pouvant être modulée en puissance ou pouvant notamment être commandée par impulsions, est couplée de manière synchronisable avec le dispositif de production de plasma et son dispositif de déplacement de champ magnétique.

12. Dispositif de magnétron producteur de plasma selon l'une quelconque des revendications précédentes, caractérisé en ce que celui-ci est un dispositif de pulvérisation et/ou un dispositif d'attaque décapante et/ou un dispositif de CVD (dépôt chimique en phase vapeur) sous plasma.
